Europäisches Patentamt

European Patent Office

Office européen des brevets

(19)

(11) **EP 1 316 806 A1**

(12) **EUROPEAN PATENT APPLICATION**

(43) Date of publication:
**04.06.2003 Bulletin 2003/23**

(51) Int Cl.$^7$: **G01R 29/08**

(21) Application number: **01128233.2**

(22) Date of filing: **28.11.2001**

| (84) Designated Contracting States:<br>**AT BE CH CY DE DK ES FI FR GB GR IE IT LI LU MC NL PT SE TR**<br>Designated Extension States:<br>**AL LT LV MK RO SI** | (72) Inventors:<br>• **Yhland, Klas**<br>  **43063 Hindas (SE)**<br>• **Stenarson, Jörgen**<br>  **41324 Göteborg (SE)** |
|---|---|
| (71) Applicant: **SP Sveriges Provnings- & Forskningsinstitut**<br>**50115 Borås (SE)** | (74) Representative: **Lind, Urban**<br>**Awapatent AB,**<br>**P.O. Box 11394**<br>**404 28 Göteborg (SE)** |

(54) **Non-contact measuring probe device for directional detection of an electromagnetic wave and measuring method**

(57)     The device comprises a loop arrangement (1) having a first and a second connection point (1a,1b), being connectable with an analysing equipment having a first and a second input channel having a first and a second input impedance ($Z_1$,$Z_2$), respectively. The loop arrangement (1) is arranged to be positioned in proximity with said surface waveguide, in which case a probe signal is generated due to inductance as well as capacitance between said waveguide and said loop arrangement (1) as a result of said electromagnetic wave propagating along said surface waveguide.

The invention further relates to a method for non-contact measurements of an electromagnetic wave, and a system for such measurements.

Fig. 4

## Description

Technical field of the Invention

This invention relates to a non-contact measuring probe device for directional detection of an electromagnetic wave travelling along a surface waveguide, e.g. an essentially unshielded transmission line, or properties of such a wave, as well as to a system utilising such a measuring probe device.

The invention also relates to a method for non-contact measuring of an electromagnetic wave travelling along a surface waveguide, or properties of such a wave.

Background art

When designing and testing a transmission line system, such as a microwave system, there is often a need to test or trim sub-circuits of the system in order to ensure the circuit function. In a system having coaxial interfaces between each sub-circuit it is easy to disconnect and measure sub-circuits. However, hybrid integrated circuits are gaining a more wide spread acceptance and are used for multiple applications. On this kind of hybrid integrated circuits, in which an entire system is integrated on a single circuit board, the above-mentioned sub-circuit test is more difficult to achieve. In accordance with the prior art, one way of achieving such measurements is by mechanically cutting the circuit board into smaller pieces, each corresponding to a sub circuit to be measured. However, this approach has the disadvantage that it is difficult to get a full picture of the functionality of the circuit. Furthermore, it is not applicable in series production.

Another approach is to disconnect the sub-circuit from the rest of the system and to contact it with conventional contacting microwave probes. However, both of the above methods are time consuming and require physical modifications of the circuit board.

Therefore, efforts have been made to develop measurement techniques, for non-contact measurements. It has also been found that, by applying a test signal through the system itself, instead of through a probe, it is possible to measure parameters of circuit without making any physical alterations of the systems.

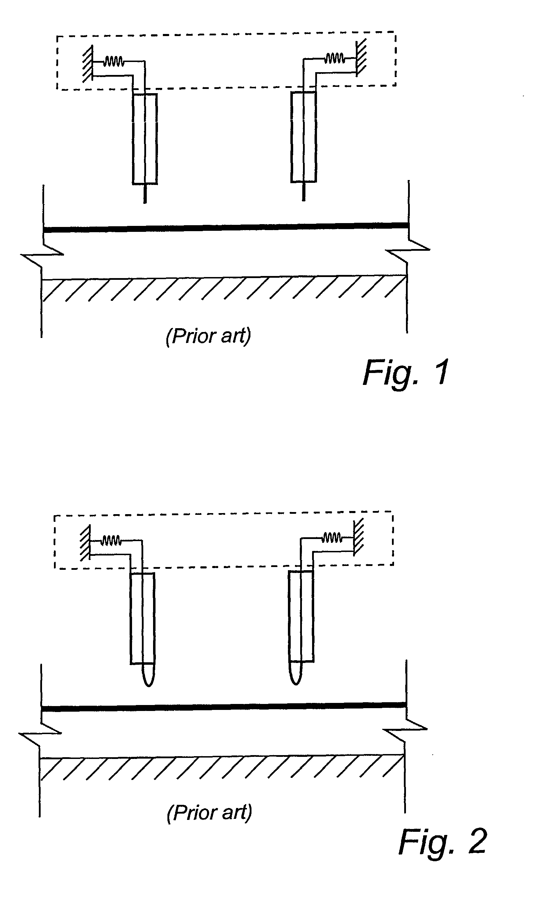

Two such measurement systems, as suggested in the prior art, are shown in fig 1 and 2, respectively. The first method, as shown in fig 1, utilises two capacitive probes, each essentially comprising a coaxial wire having a free end, whereby said probes are positioned in two locations along a transmission line, in which the electromagnetic wave shall be measured. By measuring the field at two points along a transmission line, it is possible to calculate the propagating waves along that line. The measurement system shown in fig 2 essentially works in the same way, however utilising inductive probes, instead of capacitive probes, in order to measure the field.

However, both of the above-described measurement systems have the disadvantage that the probes must be separated by a certain distance, in order to allow the calculation of the travelling waves. Ideally, the separation between the probes shall be a quarter wavelength, resulting in difficulties when measuring over a wide frequency band, as this requires movement of the probes during a frequency sweep. Furthermore, the above-described measurement systems have the disadvantage that they cannot be used in systems having a separation between the sub-circuits that is smaller than the required separation between the probes. Unfortunately, as circuits get smaller and smaller, this is more often the case.

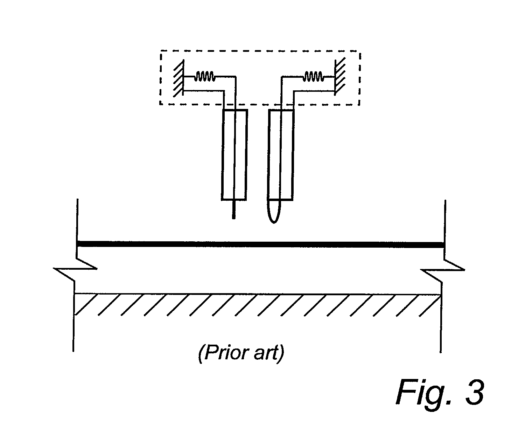

One way to solve the above-stated problems has been proposed, as shown in fig 3. This construction comprises a first inductive probe and a second capacitive probe, being placed close together.

However, both capacitive and inductive probes as suggested by the prior art, for example as shown in fig 1-3, suffer from the disadvantage that the coupled signal amplitude will vary substantially with frequency, especially for highly reflective loads. This is a problem when using instruments which need to lock to one of the signals. Therefore, there is a need for other devices for such measurements.

Summary of the invention

Consequently, an object of the present invention is to achieve a measurement system for transmission line systems, overcoming the above-described disadvantages with the prior art. Furthermore, an object of the invention is to achieve a test and measurement system that is robust and may be used on compact circuit boards.

These and other objects are achieved by a non-contact measuring probe device as described by way of introduction, being characterised in that said device comprising a loop arrangement having a first and a second connection point, being connectable with an analysing equipment having a first and a second input channel having a first and second input impedance, respectively, said loop arrangement being arranged to be positioned in proximity with said surface waveguide, in which case a probe signal is generated due to inductance as well as capacitance between said waveguide and said loop arrangement as a result of said electromagnetic wave propagating along said surface waveguide. By utilising such a measuring device, a compact and robust directional measurement probe may be achieved. Said capacitance between said waveguide and said loop arrangement give rise to a voltage over each of said input impedances having mutually equal polarity and said inductance between said waveguide and said loop arrangement give rise to a voltage over each of said input impedances having mutually opposite polarity, when an electromagnetic wave is propagating through said waveguide. Thereby, a probe is achieved by which the direction, amplitude and phase of a wave, propagating along said waveguide may be measured.

Suitably, a first transmission line is connected between said first connection point and a first input port, being arranged to be connected with said first input channel and, correspondingly, a second transmission line is connected between said second connection point and a second input port, being arranged to be connected with said second input channel. Thereby, the measuring device may easily be used in a lab using standard analysing equipment. Furthermore, unnecessary disturbances are avoided. Preferably, said transmission lines are coaxial cable transmission lines or alternatively non-shielded transmission lines, such as microstrip transmission lines, coplanar waveguides or slot lines.

In accordance with a preferred embodiment of the invention, said loop arrangement comprises a single loop-shaped conducting element, extending between said first and second connection points, thereby providing a simple probe, being comparatively easy and cost efficient to manufacture. Suitably, said loop-shaped conducting element is manufactured in one piece with a conductor of each of said transmission lines.

In accordance with a second embodiment of the invention, said loop arrangement comprises two separated loop-shaped conducting elements, whereby each conducting element in one end constitutes said first or second connection point, respectively, and in its other end it is terminated by means of a terminating impedance having a nominal value equal to a corresponding input impedance, respectively. This construction is advantageous in that it is less sensitive for reflections within the measuring device.

Preferably, each of said transmission lines and potential terminating impedances as well as the input impedances of said analysing equipment have the same nominal impedance value, thereby avoiding internal reflections.

According to an alternative embodiment of this invention, said non-contact measuring probe device comprises a loop arrangement having a first connection point, being connectable with an analysing equipment having an input channel having a first input impedance, said loop arrangement being arranged to be positioned in proximity with said surface waveguide, in which case a probe signal is generated due to inductance as well as capacitance between said waveguide and said loop arrangement as a result of said electromagnetic wave propagating along said surface waveguide. By using a loop arrangement having a single connection point, it is possible to achieve a simple probe for measuring the direction and amplitude of a wave propagating along the a waveguide. Preferably, said capacitance between said waveguide and said loop arrangement give rise to a first voltage over said input impedance and said inductance between said waveguide and said loop arrangement give rise to a second voltage over each of said input impedance, when an electromagnetic wave is propagating through said waveguide, said voltages being dependant upon the electromagnetic wave propagation direction. Moreover, said loop arrangement suitably comprises a conducting element, in one end constituting said first connection point, and in its other end being terminated by means of a terminating impedance.

Suitably, the measuring device may be used for directive wave measurements, wherein said measuring device is connected with an analysing equipment being one of a vector network analyser or a scalar network analyser. Alternatively, the measuring device may also be used for power measurements, wherein said measuring device is connected with an analysing equipment being one of a spectrum analyser or a power meter. In all cases, a robust measuring device is provided.

The above-mentioned objects of the invention are achieved by a method for non-contact measuring of an electromagnetic wave travelling along a surface waveguide, or properties of such a wave, comprising the steps of arranging a measuring probe device, in proximity with said waveguide, said device having a loop arrangement being an unshielded conductor, said loop arrangement being connectable with an analysing equipment having a first and a second input channel having a first and second input impedance, respectively, feeding a test signal to said waveguide from a signal generator, measuring a first voltage over said first input impedance, said voltage being due to inductance as well as capacitance between the loop arrangement and the waveguide as a result of said test signal, measuring a second voltage over said second input impedance, said voltage being due to inductance as well as capacitance between the loop arrangement and the waveguide as a result of said test signal, calculating, from values of said first and second voltage separated wave information regarding forward and backward propagating waves in said waveguide. Said capacitance between said waveguide and said loop arrangement give rise to a voltage over each of said input impedances having mutually equal polarity and said inductance between said waveguide and said loop arrangement give rise to a voltage over each of said input impedances having mutually opposite polarity, when an electromagnetic wave is propagating through said waveguide.

The objects are also achieved by a system for non-contact measurements of an electromagnetic wave travelling along a surface waveguide, comprising a test unit, in which a circuit board may be placed, said circuit board including a sub-circuit that is to be tested, said sub-circuit being connected with other circuit board parts by means of one or more waveguides, at least one measuring probe device, as described in any one of the claims 1-11, being placeable in proximity with said waveguide in at least one measurement position along said waveguide, and an analyser, for analysing measurement signals from said at least one measurement probe device.

## Brief description of the drawings

A currently preferred embodiment of the present invention will now be described in closer detail, with reference to the accompanying drawings.

Fig 1 discloses a prior art system for waveguide measurement, including two spaced capacitive probes.

Fig 2 discloses another prior art system for waveguide measurement, including two spaced inductive probes.

Fig 3 discloses yet another prior art system for waveguide measurement, including two probes positioned close to each other, an inductive probe and a capacitive probe.

Fig 4 is a schematic side view of a first embodiment of the present invention.

Fig 5 is a schematic side view of a second embodiment of the present invention.

Fig 6 is a schematic drawing, showing a system in which a measurement system as disclosed in fig 4 or 5 may be utilized.

Fig 7 is a schematic perspective view of a third embodiment of this invention.

Fig 8 is a schematic side view of a fourth embodiment of this invention.

Fig 9 is a schematic side view of a fifth embodiment of this invention.

## Detailed description of preferred embodiments of the Invention

In accordance with the invention, as stated above, a combined capacitive and inductive measurement probe arrangement is achieved.

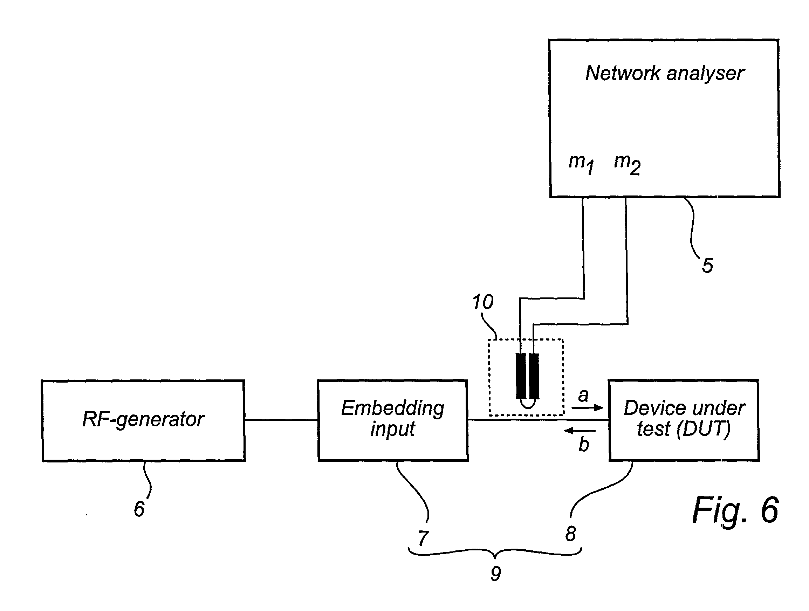

Fig 6 discloses a system in which such an arrangement may be used to measure electromagnetic waves, propagating in a surface waveguide or transmission line. This system comprises a sub-circuit 8, here referred to as a device under test (DUT), for which propagating waves a,b is to be measured. Furthermore, the system comprises an embedding input circuit 7. Here, the device under test 8 and the embedding input circuit 7 are integrated on a hybrid circuit board 9. The embedding input circuit 7 is connected with the DUT 8 by means of an input waveguide, being a surface waveguide, such as an unshielded transmission line.

When the DUT 8 is to be tested, a signal generator 6, here an RF generator is connected to the embedding input 7. Thereby, it is possible to send a signal to the DUT 8, by letting it propagate through the embedding input circuit 7 on its way to and from the DUT 8. Consequently, the signal reaching the DUT 8 has propagated the same way, and has confronted the same components, as a signal would have done, when using the circuit for its intended use. Thereby, a realistic testing may be accomplished. Naturally, measurements may also be done on the DUT 8 during its intended operation.

Furthermore, in order to perform a test measurement on said DUT 8, a measuring probe device 10 is arranged, and it is to such measuring probe devices that this invention relates. The measuring probe device 10 is arranged in proximity with, however not contacting, the input waveguide. The measuring probe device 10 is connected with an analysing equipment 5, here a vector network analyser (VNA). Said network analyser may further be integrated with said RF generator. However, the use of other corresponding analysing devices is possible, such as scalar network analysers. The measuring probe device is connected with the VNA via VNA inputs $m_1$ and $m_2$.

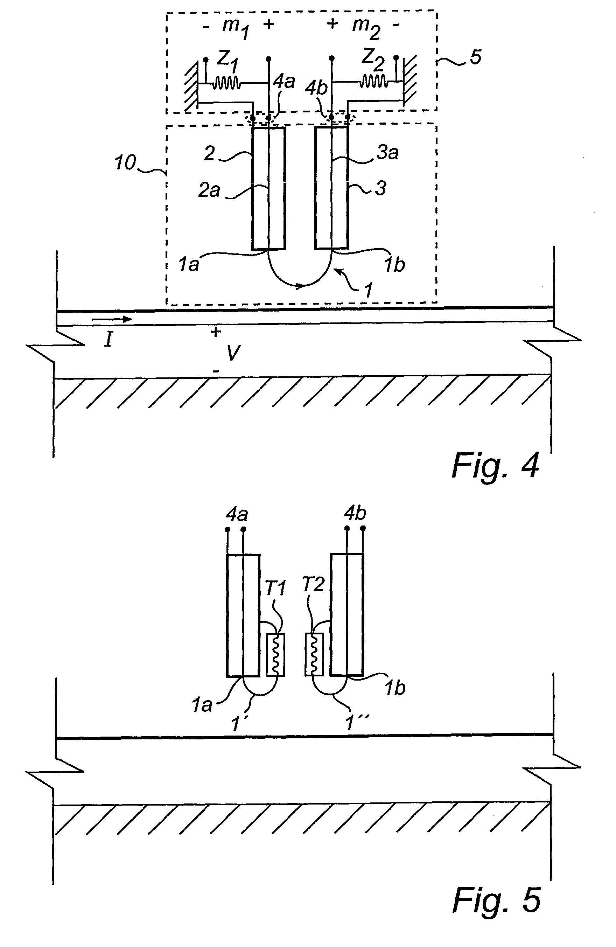

In fig 4, a first embodiment of a measuring probe device 10 in accordance with this invention is shown. In the following, reference will be made to a probe being positioned on the input side of the DUT in the above-described implementation. However, the measuring probe device may be used for measurements in other positions in the system. The embodiment showed in fig 4 essentially comprises a loop arrangement 1, being a loop-shaped unshielded electrode. In both ends, first and second connection points 1a, 1b are defined. The first connection point 1a is connected with a first transmission line 2, and the second connection point 1b is connected with a second transmission line 3. In this embodiment said transmission lines 2,3 comprise coaxial cables, wherein said loop-shaped unshielded electrode is directly connected with a first and second centre electrode 2a, 3a, respectively, of the coaxial cables 2, 3. Preferably, said centre electrodes 2a, 3a and said loop arrangement 1 are formed in one continuous piece, said loop arrangement 1 essentially being a arrangement of a coaxial cable, in which the outer electrode, surrounding said centre electrode, has been removed. Further, a first and a second input port 4a, 4b is formed by the free end of each of said centre electrodes together with a respective connection from the transmission line shielding, as seen in fig 4. Each of said input ports 4a, 4b is arranged to be connected with a first and a second input channel $m_1$, $m_2$ of said analysing equipment 5 as seen in fig 6. Further, said first and second input channels exhibit a first and a second input impedance $Z_1$, $Z_2$, respectively.

For microwave applications, a common characteristic impedance for measurement instruments is $50\Omega$. Therefore, for such applications, the first and second input impedances $Z_1$, $Z_2$, as well as said transmission lines 2, 3, have the nominal characteristic impedance value $50\Omega$, in order to avoid reflections. However, other impedance values are possible for other applications.

When using the test system for measurement as shown in fig 6, a measuring device 10, as described above, is arranged over said input waveguide of the circuit.

Furthermore, in the network analyser, measuring means for measuring a first voltage $m_1$ over said first input impedance $Z_1$ is arranged. Correspondingly, second means for measuring a second voltage $m_2$ over said second input impedance $Z_2$ is arranged. Thereafter, the voltages $m_1$ and $m_2$ are transmitted to a calculation unit in said network analyser for further processing.

Hereinafter, the course of action will be described for the measuring probe device 10.

When a signal is sent through the input connection of the DUT 8, said signal comprising a forward wave a and a backward wave *b*, a magnetic field of the electromagnetic wave in said input waveguide induces current signals in the loop arrangement 1 of said measuring probe device 10. These current signals are allowed to propagate through the transmission lines 2, 3, connected with said loop arrangement 1, and give rise to an inductive voltage over the input impedances $Z_1$, $Z_2$ of the analysing equipment 5, being connected with the transmission lines 2,3 as described above.

Furthermore, since the loop arrangement of the test probe device is arranged to be placed at a distance from said surface waveguide, a capacitive voltage is also generated between said loop arrangement and the surface waveguide, due to an electrical field around the surface waveguide. This capacitive voltage give rise to yet a voltage over said input impedances $Z_1$, $Z_2$ of the analysing equipment.

However, due to the fact that these voltages are generated in different ways, the inductive and capacitive voltages will have the same polarity over one of said impedances, while having opposite polarity over the other impedance. Thereby:

$$m_1 = V_C - V_I$$

$$m_2 = V_C + V_I$$

where $m_1$ is the voltage over the first input impedance $Z_1$, $m_2$ is the voltage over the second input impedance $Z_2$, $V_C$ is the voltage contribution due to capacitive effects, and $V_I$ is the voltage contribution due to inductive effects.

Thereby, by adjusting the measuring probe device in an appropriate way, it is possible to achieve a measuring device for which the total voltage over a first input impedance, when taking generated inductive and capacitive voltages into account, is zero for electromagnetic waves propagating in one direction, while the total voltage over a second input impedance, is zero for waves propagating in the opposite direction. Thereby, by measuring the voltage over $Z_1$ and $Z_2$, the propagation direction of the wave may be detected, and a directive test probe device is achieved. Further, in the above cases, the amplitude of the propagating wave may be detected by measuring the non-zero voltage over a corresponding other impedance, as indicated by the formula above.

The above measurement probe is however not limited to electromagnetic waves propagating in solely one direction but may also be used to measure bi-directional wave patterns in a corresponding manner.

Furthermore, as is obvious from the above stated, a wave propagating in one direction along the waveguide, will result in values of $V_I$ having one polarity, while a wave in the opposite direction will result in a value of $V_I$ having opposite polarity.

For measurements, the measurement system shall be calibrated, whereby a determined distance between the probe and waveguide is used. When measuring, the same distance shall be utilised.

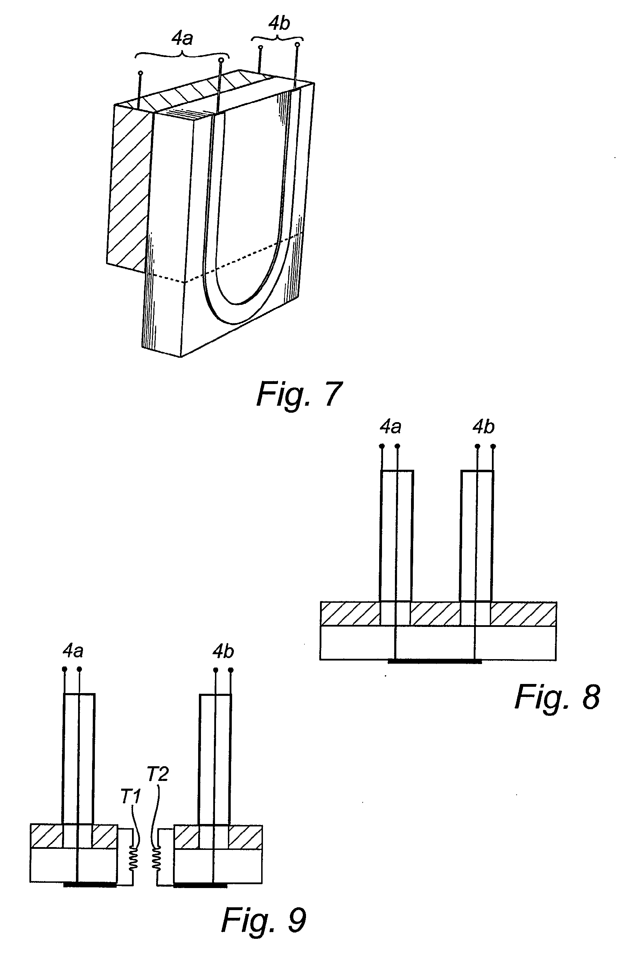

Another embodiment, utilising the above principle is shown in fig 7. Here, the transmission lines, as well as the loop arrangement is provided in one piece on a printed circuit board, whereby the ground layer is removed in the area of the loop arrangement. The function of this device is as described above.

Yet another embodiment of the invention utilising the above principle is shown in fig 8. Here, the loop arrangement is provided as a printed strip on a circuit board, whereby said strip is connected with the transmission lines through openings in the circuit board ground plane and the dielectric plane, as shown in fig 8. The transmission lines may be shielded or unshielded.

The above-described embodiments all disclose constructions in which the loop arrangement directly connects the transmission lines with each other. However, in certain sensitive applications the embodiments described below may be preferable.

Yet another embodiment of the invention is shown in fig 5. Regarding the transmission lines and the input ports being connectable with analysing equipment 5, this embodiment is identical with the one showed in fig 4, whereby a closer description of those parts is excluded.

However, in this embodiment, the loop arrangement comprises a first and a second loop part 1', 1", that are separated from each other. The first loop part 1' comprises a loop-shaped portion extending between the first connection point 1a and a first termination resistor T1. In the same way, the second loop part 1" comprises a loop-shaped portion extending between the second connection point 1b and a second termination resistor T1. Both termination resistors T1, T2 have a resistance value corresponding with the characteristic impedance of the system, thereby avoiding unnecessary reflections. The free end of each of said termination resistors T1, T2 are connected with the shielding of the transmission line 2,3, respectively. The two loop parts 1', 1" are preferably placed close together, in order to provide a compact solution.

In a similar way as described above, when a test signal is sent is sent through the DUT , the magnetic field of the electromagnetic wave in said input waveguide generates current signals in the first and second loop parts 1', 1" of said probe device. These current signals are allowed to propagate through the transmission lines 2, 3, connected with the respective one of said loop parts. As a result, the current generated in said first loop part 1' give rise to an inductive voltage over the first input impedance $Z_1$ of the analysing equipment 5, being connected with the first transmission line 2 as described above. Similarly, the current induced in said second loop part 1" give rise to a inductive voltage over the second input impedance $Z_2$ of the analysing equipment 5, being connected with the second transmission line 3 as described above.

Furthermore, since the loop parts of the test probe device is arranged to be placed at a distance from said surface waveguide, a capacitive voltage is also induced between said loop parts and the surface waveguide, due to the electrical field around the surface waveguide. This capacitive voltage give rise to yet a voltage over said first and second input impedances $Z_1$, $Z_2$, respectively.

In the same way as described above, due to the fact that these voltages are induced in different ways, the inductive and capacitive voltages will have the same polarity over one of said resistors, while having opposite polarity over the other resistor.

An alternative embodiment is shown in fig 9. As in the above-described construction, the loop arrangement comprises two loop parts. Each loop part is provided as a printed strip on a circuit board, whereby said strip is connected with the transmission line through an opening in the circuit board, as shown in fig 9. The transmission lines may be shielded or unshielded. Furthermore, each loop part is terminated by means of a termination resistor T1, T2 being connected between the strip and the ground plane of the circuit board. In a corresponding way, a construction as shown in fig 7 may be divided into a first and a second terminated loop part.

These embodiments, as described with reference to fig 5 and 9 are less sensitive to reflections than the previously described embodiments of the invention.

The present invention should however not be considered as being limited to the above-described embodiment, but rather includes all possible variations covered by the scope defined by the appended claims.

An alternative embodiment of this invention may for example be used for measurements in which information regarding only the direction and amplitude of the propagating wave is desired. Such a measurement device may be comprised by a loop arrangement comprising a conducting element, in one end constituting a first connection point, and in its other end being terminated by means of a terminating impedance. The first connection point is connectable with an analysing equipment having an input channel having a first input impedance, said loop arrangement being arranged to be positioned in proximity with said surface waveguide, in which case a probe signal is generated due to inductance as well as capacitance between said waveguide and said loop arrangement as a result of said electromagnetic wave propagating along said surface waveguide. In principle, the device shown in any of fig 5 or fig 9 may be said to comprise two such measurement devices, being placed in close proximity with each other. Such a measurement device, using a single input connection of for example a spectrum analyser, a scalar network analyser or a power meter. By using such a single input connection measurement probe, instead of the dual input connection devices described above and showed in for example fig 4, a more simple device may be achieved, for measuring direction and amplitude only, which is adequate in certain applications.

Moreover, a measuring probe device as described above may be used with a plurality of analysing equipments, such as vector network analysers and scalar network analysers. Furthermore, it is possible to use the measuring probe device for power measurements, then connected with a power meter or a spectrum analyser. Other uses are also possible.

Furthermore, it is obvious for a man skilled in the art, that this invention may be realised using a variety of techniques, without departing from the scope and spirit of this invention.

## Claims

1. A non-contact measuring probe device for directional detection of an electromagnetic wave travelling along a surface waveguide, or properties of such a wave, **characterised in that** said device comprises a loop arrangement (1) having a first and a second connection point (1a, 1b), being connectable with an analysing equipment (5) having a first and a second input channel having a first and second input impedance ($Z_1$, $Z_2$), respectively, said loop arrangement (1) being arranged to be positioned in proximity with said surface waveguide, in which case a probe signal is generated due to inductance as well as capacitance between said waveguide and said loop arrangement (1) as a result of said electromagnetic wave propagating along said surface waveguide.

2. A measuring device as in claim 1, wherein said capacitance between said waveguide and said loop arrangement (1) give rise to a first voltage over each of said input impedances ($Z_1$, $Z_2$) having mutually equal polarity and said inductance between said waveguide and said loop arrangement (1) give rise to a voltage over each of said input impedances ($Z_1$, $Z_2$) having mutually opposite polarity, when an electromagnetic wave is propagating through said waveguide.

**3.** A measuring device as in claim 1 or 2, wherein a first transmission line (2) is connected between said first connection point (1a) and a first input port (4a), being arranged to be connected with said first input channel and, correspondingly, a second transmission line (3) is connected between said second connection point (1b) and a second input port (4b), being arranged to be connected with said second input channel.

**4.** A measuring device as in claim 3, wherein said transmission lines (2,3) are coaxial cable transmission lines.

**5.** A measuring device as in claim 3, wherein said transmission lines (2,3) are non-shielded transmission lines, such as microstrip transmission lines, coplanar waveguides or slot lines.

**6.** A measuring device as in any one of the claims 1-5, wherein said loop arrangement (1) comprises a single loop-shaped conducting element, extending between said first and second connection points (1a, 1b).

**7.** A measuring device as in claim 6, wherein said loop-shaped conducting element is manufactured in one piece with a conductor (2a, 3a) of each of said transmission lines (2,3).

**8.** A measuring device as in any one of the claims 1-5, wherein said loop arrangement (1) comprises two separated loop-shaped conducting elements (1', 1"), whereby each conducting element (1',1") in one end constitutes said first or second connection point (1a,1b), respectively, and in its other end is terminated by means of a terminating impedance (T1, T2).

**9.** A measuring device as in any one of the claims 2-8, wherein a characteristic impedance of each of said transmission lines (2, 3) and potential terminating impedances (T1, T2) as well as the input impedances ($Z_1$, $Z_2$) of said analysing equipment (5), have the same nominal impedance value.

**10.** A non-contact measuring probe device for directional detection of an electromagnetic wave travelling along a surface waveguide, or properties of such a wave, **characterised in that** said device comprises a loop arrangement (1') having a first connection point (1a), being connectable with an analysing equipment (5) having an input channel having a first input impedance ($Z_1$), said loop arrangement (1') being arranged to be positioned in proximity with said surface waveguide, in which case a probe signal is generated due to inductance as well as capacitance between said waveguide and said loop arrangement (1') as a result of said electromagnetic wave propagating along said surface waveguide.

**11.** A measuring device as in claim 10, wherein said capacitance between said waveguide and said loop arrangement (1') give rise to a first voltage over said input impedance ($Z_1$) and said inductance between said waveguide and said loop arrangement (1') give rise to a second voltage over said input impedance ($Z_1$), when an electromagnetic wave is propagating through said waveguide, said voltages being dependant upon the electromagnetic wave propagation direction.

**12.** A measuring device as in claim 10 or 11, wherein said loop arrangement (1') comprises a conducting element, in one end constituting said first connection point (1a), and in its other end being terminated by means of a terminating impedance (T1).

**13.** Use of a measuring device in accordance with any one of the claims 1-12 for directive wave measurements, wherein said measuring device is connected with an analysing equipment (5) being a vector network analyser.

**14.** Use of a measuring device in accordance with any one of the claims 1-12 for directional wave measurements, wherein said measuring device is connected with an analysing equipment (5) being one of a spectrum analyser, a scalar network analyser or a power meter.

**15.** A method for non-contact measuring of an electromagnetic wave travelling along a surface waveguide, or properties of such a wave, comprising the following steps:

- arranging a measuring probe device, in proximity with said waveguide, said device having a loop arrangement (1) being an unshielded conductor, said loop arrangement (1) being connectable with an analysing equipment (5) having a first and a second input channel having a first and second input impedance ($Z_1$, $Z_2$), respectively,
- feeding a test signal to said waveguide from a signal generator,
- measuring a first voltage (V1) over said first input impedance ($Z_1$), said voltage being due to inductance as well as capacitance between the loop arrangement (1) and the waveguide as a result of said test signal,
- measuring a second voltage (V2) over said second input impedance ($Z_2$), said voltage being due to inductance as well as capacitance between the loop arrangement (1) and the waveguide as a result of said test signal,
- calculating, from values of said first and second voltage (V1, V2) separated wave information regarding forward and backward propagating waves in said waveguide.

16. A method in accordance with claim 15, wherein said capacitance between said waveguide and said loop arrangement (1) give rise to a voltage over each of said input impedances ($Z_1$, $Z_2$) having mutually equal polarity and said inductance between said waveguide and said loop arrangement (1) give rise to a voltage over each of said input impedances ($Z_1$, $Z_2$) having mutually opposite polarity, when an electromagnetic wave is propagating through said waveguide.

17. A method in accordance with claim 15 or 16, wherein the step of arranging a measuring probe device further includes the step of:

- arranging a measuring probe device as described in any one of the claims 1-12.

18. System for non-contact measurements of an electromagnetic wave travelling along a surface waveguide, comprising:

- a test unit, in which a circuit board may be placed, said circuit board including a sub-circuit that is to be tested, said sub-circuit being connected with other circuit board parts by means of one or more waveguides,
- at least one measuring probe device, as described in any one of the claims 1-12, being placeable in proximity with said waveguide in at least one measurement position along said waveguide,
- an analyser, for analysing measurement signals from said at least one measurement probe device.

(Prior art)

*Fig. 1*

(Prior art)

*Fig. 2*

(Prior art)

Fig. 3

Fig. 4

Fig. 5

Fig. 6

4a 4b

Fig. 7

4a 4b

Fig. 8

4a 4b

T1 T2

Fig. 9

European Patent
Office

**EUROPEAN SEARCH REPORT**

Application Number

EP 01 12 8233

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 325 019 A (MILLER PAUL A ET AL) 28 June 1994 (1994-06-28) * abstract; figure 2 * | 1-18 | G01R29/08 |
| A | US 5 594 332 A (HARMAN R KEITH ET AL) 14 January 1997 (1997-01-14) * abstract * | 1 | |
| A | US 5 231 346 A (GASSMANN FELIX) 27 July 1993 (1993-07-27) * abstract; figure 1A * | 1 | |
| A | JOHNSTON R H: "Measurement of modes in an overmoded circular waveguide" CIRCUITS AND SYSTEMS, 1997. PROCEEDINGS OF THE 40TH MIDWEST SYMPOSIUM ON SACRAMENTO, CA, USA 3-6 AUG. 1997, NEW YORK, NY, USA,IEEE, US, 3 August 1997 (1997-08-03), pages 599-602, XP010272474 ISBN: 0-7803-3694-1 * the whole document * | 1,15 | |

TECHNICAL FIELDS
SEARCHED (Int.Cl.7)

G01R

The present search report has been drawn up for all claims

| Place of search | Date of completion of the search | Examiner |
|---|---|---|
| THE HAGUE | 22 May 2002 | Vytlacilová, L |

EPO FORM 1503 03.82 (P04C01)

**ANNEX TO THE EUROPEAN SEARCH REPORT
ON EUROPEAN PATENT APPLICATION NO.**                    EP 01 12 8233

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2002

| Patent document cited in search report | | Publication date | Patent family member(s) | | Publication date |
|---|---|---|---|---|---|
| US 5325019 | A | 28-06-1994 | NONE | | |
| US 5594332 | A | 14-01-1997 | CA | 2160295 A1 | 13-04-1996 |
| US 5231346 | A | 27-07-1993 | DE | 59203328 D1 | 28-09-1995 |
|  |  |  | EP | 0501169 A1 | 02-09-1992 |
|  |  |  | JP | 5060815 A | 12-03-1993 |

EPO FORM P0459

For more details about this annex : see Official Journal of the European Patent Office, No. 12/82